# EUROPEAN PATENT APPLICATION

(11) **EP 4 797 264 A1**
(43) Date of publication of application: **26.08.2026**
(21) Application number: 26152438.3
(22) Date of filing: 16.01.2026
(51) Int. Cl.: G11C 7/10, G06F 7/544, G06G 7/163, G06N 3/065, G11C 13/00, G11C 11/54

(54) **ANALOG IN-MEMORY COMPUTING DEVICE FOR NEURAL NETWORK**

(30) Priority: 21.02.2025 US 202519059259
(71) Applicant: OmniVision Technologies, Inc., Santa Clara California 95054 (US)
(72) Inventor: SAITO, Daisuke, Santa Clara, CA 95054 (US)
(74) Representative: Mewburn Ellis LLP

(57) **Abstract**

An analog in-memory computing device (100) for a neural network is provided. The analog in-memory computing device (100) includes a memristor array (120) and a readout circuit (140). The readout circuit (140) includes a differential amplifier circuit (AMP3, AMP4, AMP5, AMP6) and a plurality of current-voltage conversion circuits (CVC31 to CVC3n, CVC41 to CVC4n, CVC51 to CVC5n, CVC61 to CVC6n). A first input terminal of the differential amplifier circuit (AMP3, AMP4, AMP5, AMP6) is coupled to a reference voltage source (Vref). Each second input terminal of the differential amplifier circuit (AMP3, AMP4, AMP5, AMP6) is coupled to a corresponding column line of the memristor array (120). A first terminal of each current-voltage conversion circuit (CVC31 to CVC3n, CVC41 to CVC4n, CVC51 to CVC5n, CVC61 to CVC6n) is coupled to a corresponding column line. A second terminal of each current-voltage conversion circuit (CVC31 to CVC3n, CVC41 to CVC4n, CVC51 to CVC5n, CVC61 to CVC6n) is coupled to a corresponding output terminal of the differential amplifier circuit (AMP3, AMP4, AMP5, AMP6). Each current-voltage conversion circuit (CVC31 to CVC3n, CVC41 to CVC4n, CVC51 to CVC5n, CVC61 to CVC6n) outputs a readout result voltage corresponding to a corresponding column line.

## Description

This application claims priority to US19/059,259 filed 21 February 2025.

### BACKGROUND

### Technical Field

The disclosure relates to a neural network computing device, and particularly relates to an analog in-memory computing (AIMC) device.

### Description of Related Art

Neural network computation includes a large amount of matrix multiplication. How to implement matrix multiplication circuits is one of the technical issues in this field.

### SUMMARY

The disclosure provides an analog in-memory computing (AIMC) device for a neural network, for performing matrix multiplication of the neural network.

In an embodiment of the disclosure, the analog in-memory computing device includes a memristor array and a readout circuit. The memristor array includes multiple memristor circuits, multiple column lines, and multiple row lines. The first terminal of each memristor circuit is coupled to a corresponding row line. The second terminal of each memristor circuit is coupled to a corresponding column line. The readout circuit is coupled to the column lines. The readout circuit includes a differential amplifier circuit and multiple current-voltage conversion circuits. The differential amplifier circuit includes a first input terminal, multiple second input terminals, and multiple output terminals. The first input terminal is one of an inverting input terminal and a non-inverting input terminal, while each second input terminal is the other one of the inverting input terminal and the non-inverting input terminal. The output terminals correspond to the second input terminals on a one-to-one basis. The first input terminal is coupled to a reference voltage source. Each second input terminal is coupled to a corresponding column line. The first terminal of each current-voltage conversion circuit is coupled to a corresponding column line. The second terminal of each current-voltage conversion circuit is coupled to a corresponding output terminal of the differential amplifier circuit. The output terminal of each current-voltage conversion circuit outputs a readout result voltage corresponding to a corresponding column line.

Based on the above, in various embodiments of the disclosure, the first terminal and the second terminal of each of the memristor circuits are coupled to a corresponding row line and a corresponding column line, respectively. Multiple elements of the weight matrix of the neural network are programmed in the form of conductance (reciprocal of resistance) into different memristor circuits of the memristor array, while different elements of the input matrix of a certain computation layer in the neural network are represented by multiple analog input voltages. These analog input voltages are transmitted through different row lines to different memristor circuits in the same column, causing these memristor circuits to generate different output currents to the same column line. The total current on the same column line is equivalent to the multiply accumulation result, and the different total currents on these column lines are equivalent to the matrix multiplication result of the input matrix multiplied by the weight matrix. Therefore, the analog in-memory computing device is capable of performing matrix multiplication of the neural network. Furthermore, the readout circuit of the memristor array may adopt Trans-Impedance Amplifier (TIA) technology to convert the total current on each column line into a corresponding analog output voltage. The readout circuit shares the same differential amplifier for readout operations of different column lines. Thus, the readout circuit reduces the number of transistors in the differential amplifier, which reduces the noise of the amplifier transistors.

To make the aforementioned features and advantages of the disclosure more comprehensible, exemplary embodiments are described in detail hereinafter in conjunction with the accompanying figures.

### BRIEF DESCRIPTION OF THE DRAWINGS

FIG. 1 is a circuit block diagram illustrating an analog in-memory computing device according to an embodiment.
FIG. 2 is a circuit block diagram illustrating a readout circuit according to an embodiment.
FIG. 3 is a circuit block diagram illustrating a readout circuit according to another embodiment of the disclosure.
FIG. 4 is a circuit block diagram illustrating a readout circuit according to yet another embodiment of the disclosure.
FIG. 5 is a circuit block diagram illustrating a readout circuit according to yet another embodiment of the disclosure.
FIG. 6 is a circuit diagram illustrating a differential amplifier circuit according to an embodiment of the disclosure.
FIG. 7 is a flow chart illustrating an operation method of a readout circuit according to an embodiment of the disclosure.
FIG. 8 is a circuit block diagram illustrating a readout circuit according to an embodiment of the disclosure.
FIG. 9 is a flow chart illustrating an iterative operation according to an embodiment of the disclosure.

### DESCRIPTION OF THE EMBODIMENTS

The term "couple (or connect)" used in this specification (including the claims) may refer to any direct or indirect connection means. For example, when it is described that the first device is coupled (or connected) to the second device, it should be interpreted that the first device may be directly connected to the second device, or the first device may be indirectly connected to the second device through other devices or some connection means. The terms "first", "second", and so on used in this specification (including the claims) are used to name the elements or distinguish different embodiments or ranges, and are not intended to define the upper or lower limit of the number of elements nor to limit the order of elements. In addition, elements/components/steps denoted by the same reference numerals in the drawings and embodiments represent the same or similar parts as appropriate. Descriptions of elements/components/steps using the same reference numerals or the same names in different embodiments may serve as reference for each other.

Regarding matrix multiplication operations for neural networks (for example, deep neural networks, DNN), analog in-memory computation (AIMC) is an attractive solution. Analog in-memory computation can realize low power/high efficiency operation. Analog in-memory computation occupies small space, and can be used for multiply accumulations.

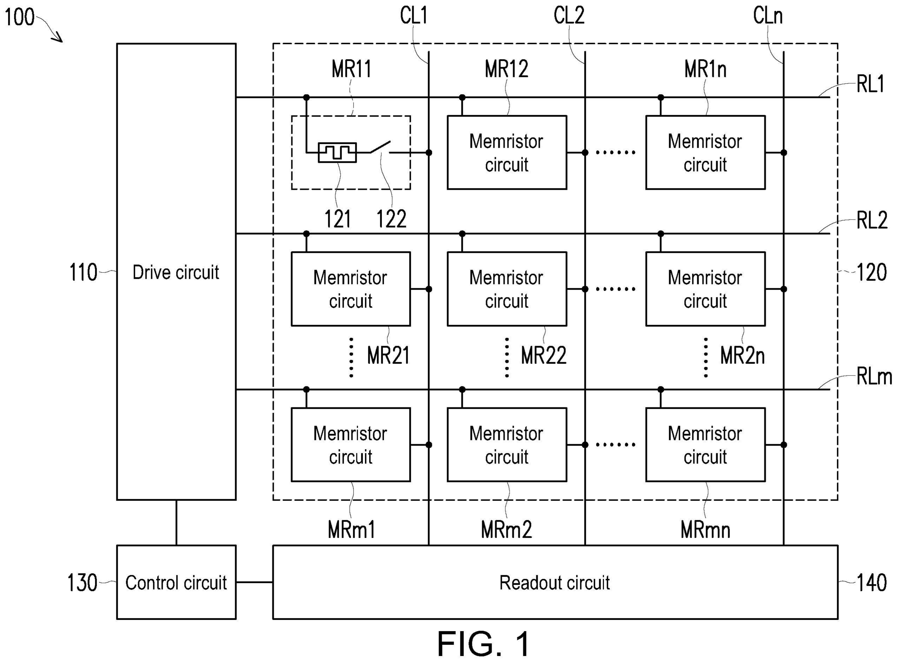

FIG. 1 is a circuit block diagram illustrating an analog in-memory computing device 100 according to an embodiment. The analog in-memory computing device 100 is used for a matrix multiplication operation of a neural network. The analog in-memory computing device 100 shown in FIG. 1 includes a drive circuit 110, a memristor array 120, a control circuit 130, and a readout circuit 140. According to different designs, in some embodiments, the drive circuit 110 and/or the control circuit 130 may be implemented as hardware circuits. In other embodiments, the drive circuit 110 and/or the control circuit 130 may be implemented in the form of a combination of hardware, firmware, and/or software (i.e., programs).

In terms of hardware, the drive circuit 110 and/or the control circuit 130 may be implemented as logic circuits on an integrated circuit. For example, the functions of the drive circuit 110 and/or the control circuit 130 may be implemented in various logic blocks, modules, and circuits in one or more hardware controllers, microcontrollers, hardware processors, microprocessors, application-specific integrated circuits (ASICs), digital signal processors (DSPs), field programmable gate arrays (FPGAs), central processing units (CPUs), and/or other processing units. The functions of the drive circuit 110 and/or the control circuit 130 may be implemented as hardware circuits, such as various logic blocks, modules, and circuits in an integrated circuit, using hardware description languages (such as Verilog HDL or VHDL) or other suitable programming languages.

In terms of software and/or firmware, the functions of the drive circuit 110 and/or the control circuit 130 may be implemented as programming codes. For example, general programming languages (such as C, C++, or composition language) or other suitable programming languages may be used to implement the drive circuit 110 and/or the control circuit 130. The programming codes may be recorded/stored in a "non-transitory machine-readable storage medium". In some embodiments, the non-transitory machine-readable storage medium may include, for example, a semiconductor memory and/or a storage device. An electronic device (such as computer, CPU, hardware controller, microcontroller, hardware processor, or microprocessor) may read and execute the programming codes from the non-transitory machine-readable storage medium to implement the functions of the drive circuit 110 and/or the control circuit 130.

The memristor array 120 may be a resistive random-access memory (ReRAM). The drive circuit 110 is controlled by the control circuit 130 to generate multiple analog input voltages to different row lines RL1, RL2, ..., RLm of the memristor array 120. The drive circuit 110 uses multiple analog input voltages to represent different elements of the input matrix of a certain computation layer in the neural network. The memristor array 120 includes multiple memristor circuits MR11, MR12, ..., MR1n, MR21, MR22, ..., MR2n, ..., MRm1, MRm2, ..., MRmn. The first terminal of each of the memristor circuits MR11 to MRmn is coupled to the corresponding one of the row lines RL1 to RLm. The second terminal of each of the memristor circuits MR11 to MRmn is coupled to the corresponding one of the column lines CL1, CL2, ..., CLn. Multiple elements of the weight matrix of the neural network are programmed in the form of conductance (reciprocal of resistance) into different memristor circuits MR11 to MRmn of the memristor array 120. Based on the control of the control circuit 130, the drive circuit 110 converts different elements representing the input matrix of a certain computation layer in the neural network into multiple analog input voltages for the row lines RL1 to RLm. These analog input voltages are respectively transmitted to the memristor circuits MR11 to MRmn through different row lines, causing the memristor circuits MR11 to MRmn to generate different output currents to the column lines CL1 to CLn.

Each of the memristor circuits MR11 to MRmn includes a memristor and a switch. For example, the memristor circuit MR11 includes a memristor 121 and a switch 122. The memristor 121 stores one of the multiple weights of the neural network. For example, an element in the weight matrix of the neural network is programmed in the form of conductance (reciprocal of resistance) into the memristor 121. The memristor 121 and the switch 122 are connected in series between the first terminal and the second terminal of the memristor circuit MR11, that is, connected in series between the row line RL1 and the column line CL1. When the switch 122 is turned on, the memristor 121 may convert the analog input voltage from the drive circuit 110 into an output current to the column line CL1. The analog input voltage of the memristor 121 represents an input element in the input matrix of a certain computation layer in the neural network, while the conductance (reciprocal of resistance) of the memristor 121 represents a weight element in the weight matrix of the neural network. Therefore, the output current of the memristor 121 is equivalent to the multiplication result of the input element and the weight element.

Other memristor circuits MR12 to MRmn in the memristor array 120 may be understood by referring to the description about the memristor circuit MR11, and thus will not be described in detail here. The memristor circuits MR11, MR21, ..., MRm1 in the same column respectively convert multiple analog input voltages from the drive circuit 110 into different output currents for the same column line CL1. Therefore, the total current on the column line CL1 is equivalent to the multiply accumulation result after accumulating different multiplication results of the memristor circuits MR11, MR21, ..., MRm1 in the same column. The different total currents on the column lines CL1 to CLn are equivalent to the matrix multiplication result of the input matrix multiplied by the weight matrix. Based on the control of the control circuit 130, the readout circuit 140 couples to the column lines CL1 to CLn to detect different total currents on the column lines CL1 to CLn, and then transmits the current detection results (matrix multiplication results) to the control circuit 130. Therefore, the analog in-memory computing device 100 is capable of performing matrix multiplication of the neural network.

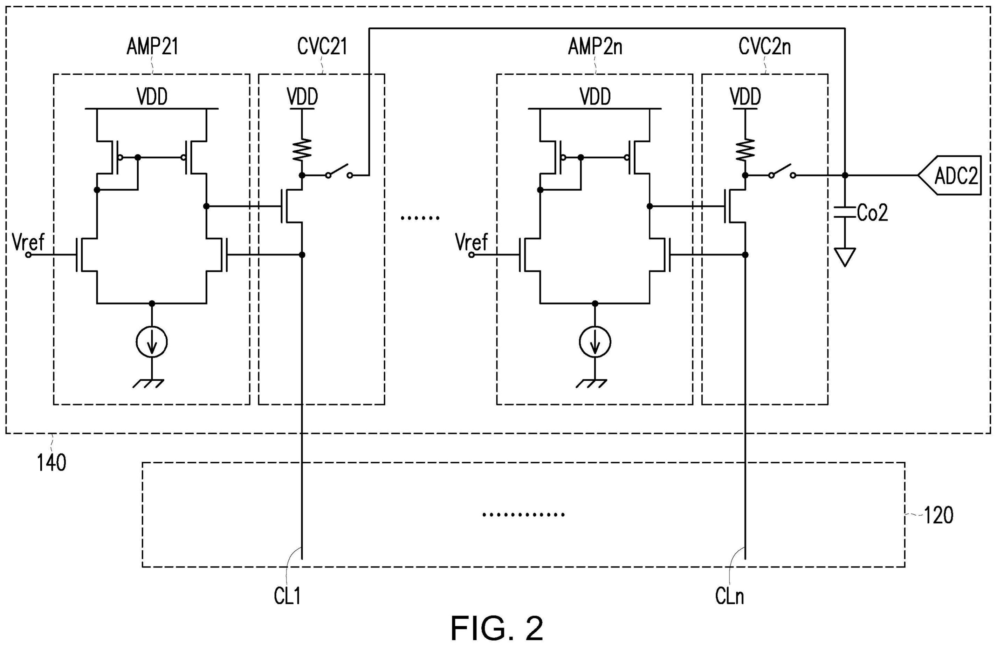

FIG. 2 is a circuit block diagram illustrating a readout circuit 140 according to an embodiment. In the embodiment shown in FIG. 2, the readout circuit 140 of the memristor array 120 may adopt Trans-Impedance Amplifier (TIA) technology to convert the total current on each of the column lines CL1 to CLn into a corresponding analog output voltage. The readout circuit 140 shown in FIG. 2 may serve as one of many exemplary embodiments of the readout circuit 140 shown in FIG. 1. The memristor array 120, the column lines CL1 to CLn, and the readout circuit 140 shown in FIG. 2 may be understood by referring to the description related to FIG. 1.

In the embodiment shown in FIG. 2, the readout circuit 140 includes multiple differential amplifiers (for example, AMP21, ..., AMP2n), multiple current-voltage conversion circuits (for example, CVC21, ..., CVC2n), an output capacitor Co2, and an analog to digital converter (ADC) ADC2. The non-inverting input terminal of the differential amplifier AMP21 is coupled to a reference voltage source Vref. The inverting input terminal of the differential amplifier AMP21 is coupled to the corresponding column line CL1 of the column lines CL1 to CLn. The first terminal of the current-voltage conversion circuit CVC21 is coupled to the corresponding column line CL1. The second terminal of the current-voltage conversion circuit CVC21 is coupled to the output terminal of the differential amplifier AMP21. The output terminal of the current-voltage conversion circuit CVC21 is coupled to the first terminal of the output capacitor Co2 and the input terminal of the analog to digital converter ADC2. The second terminal of the output capacitor Co2 is coupled to a reference voltage source, such as a ground voltage source or other fixed voltage sources. The output terminal of the current-voltage conversion circuit CVC21 outputs the readout result voltage corresponding to the corresponding column line CL1 to the output capacitor Co2 and the analog to digital converter ADC2.

Other differential amplifiers (for example, differential amplifier AMP2n) and other current-voltage conversion circuits (for example, current-voltage conversion circuit CVC2n) may be understood by referring to the description about the differential amplifier AMP21 and the current-voltage conversion circuit CVC21, and thus will not be described in detail here. The current-voltage conversion circuits CVC21 to CVC2n output the readout result voltages corresponding to different column lines CL1 to CLn to the output capacitor Co2 and the analog to digital converter ADC2 at different times. The analog to digital converter ADC2 converts the readout result voltages corresponding to the column lines CL1 to CLn into different digital data (matrix multiplication results), and transmits the digital data to the control circuit 130.

Generally, the number n of column lines CL1 to CLn is very large to facilitate large matrix multiplication. As the number of column lines CL1 to CLn increases, the number of transistors in the differential amplifiers AMP21 to AMP2n increases even more. The following embodiments will illustrate how to reduce the number of transistors in the readout circuit 140.

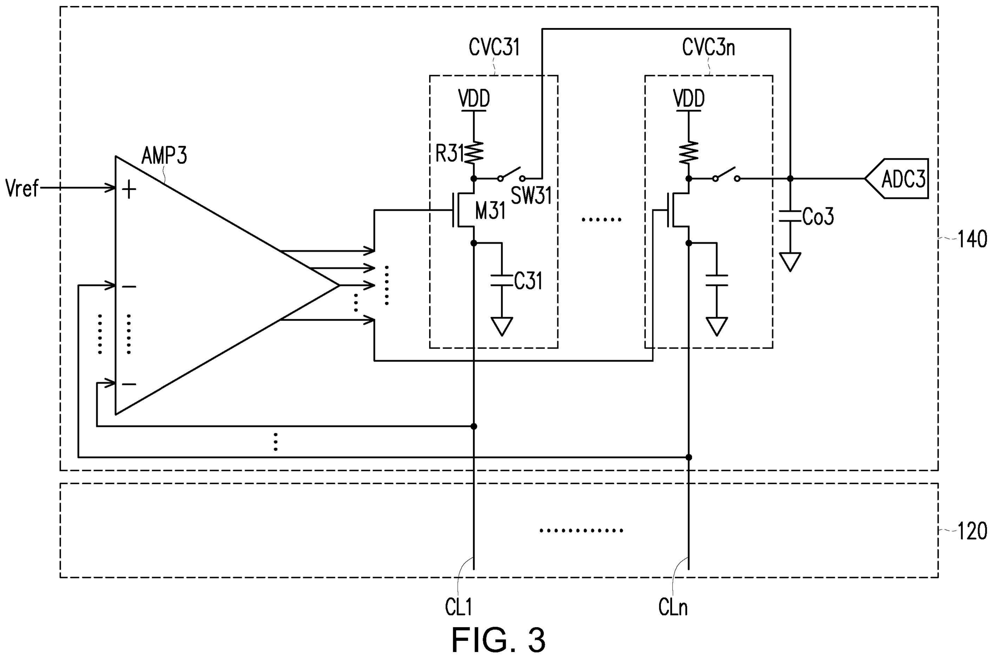

FIG. 3 is a circuit block diagram illustrating a readout circuit 140 according to another embodiment of the disclosure. The readout circuit 140 shown in FIG. 3 may serve as one of many exemplary embodiments of the readout circuit 140 shown in FIG. 1. The memristor array 120, the column lines CL1 to CLn, and the readout circuit 140 shown in FIG. 3 may be understood by referring to the description related to FIG. 1. In the embodiment shown in FIG. 3, the readout circuit 140 includes a differential amplifier circuit AMP3, multiple current-voltage conversion circuits (for example, CVC31, ..., CVC3n), an output capacitor Co3, and an analog to digital converter ADC3.

The differential amplifier circuit AMP3 has a first input terminal, multiple second input terminals, and multiple output terminals. The first input terminal is one of the inverting input terminal and the non-inverting input terminal, each of the second input terminals is the other one of the inverting input terminal and the non-inverting input terminal, and the output terminals correspond to the second input terminals on a one-to-one basis. For example, in the embodiment shown in FIG. 3, the first input terminal of the differential amplifier circuit AMP3 is the non-inverting input terminal, and each of the second input terminals of the differential amplifier circuit AMP3 is the inverting input terminal. In another embodiment, the first input terminal of the differential amplifier circuit AMP3 may be the inverting input terminal, and each of the second input terminals of the differential amplifier circuit AMP3 may be the non-inverting input terminal. The first input terminal of the differential amplifier circuit AMP3 is coupled to a reference voltage source Vref. Each of the second input terminals of the differential amplifier circuit AMP3 is coupled to the corresponding one of the column lines CL1 to CLn, as shown in FIG. 3.

The first terminal of each of the current-voltage conversion circuits CVC31 to CVC3n is coupled to the corresponding one of the column lines CL1 to CLn. The second terminal of each of the current-voltage conversion circuits CVC31 to CVC3n is coupled to the corresponding one of the output terminals of the differential amplifier circuit AMP3, as shown in FIG. 3. The output terminal of each of the current-voltage conversion circuits CVC31 to CVC3n is coupled to the first terminal of the output capacitor Co3 and the input terminal of the analog to digital converter ADC3. The second terminal of the output capacitor Co3 is coupled to a reference voltage source, such as a ground voltage source or other fixed voltage sources (different from the reference voltage source Vref). The output terminal of each of the current-voltage conversion circuits CVC31 to CVC3n outputs the readout result voltage corresponding to the corresponding one of the column lines CL1 to CLn to the output capacitor Co3 and the analog to digital converter ADC3. The column lines CL1 to CLn share the analog to digital converter ADC3 in a time-division manner. The analog to digital converter ADC3 converts the readout result voltages corresponding to the column lines CL1 to CLn into different digital data (matrix multiplication results) at different times, and transmits the digital data to the control circuit 130.

In the embodiment shown in FIG. 3, each of the current-voltage conversion circuits CVC31 to CVC3n includes a resistor, a transistor, a switch, and a capacitor. For example, the current-voltage conversion circuit CVC31 includes a resistor R31, a transistor M31, a switch SW31, and a capacitor C31. The first terminal of the resistor R31 is coupled to a power voltage source VDD. The first terminal (for example, drain) of the transistor M31 is coupled to the second terminal of the resistor R31. The second terminal (for example, source) of the transistor M31 is coupled to the corresponding column line CL1. The first terminal of the capacitor C31 is coupled to the second terminal of the transistor M31. The second terminal of the capacitor C31 is coupled to a reference voltage source, such as a ground voltage source or other fixed voltage sources (different from the reference voltage source Vref). The control terminal (for example, gate) of the transistor M31 is coupled to the corresponding output terminal of the differential amplifier circuit AMP3. The first terminal of the switch SW31 is coupled to the second terminal of the resistor R31. Through the operation of the switch SW31, the current-voltage conversion circuit CVC31 may use the analog to digital converter ADC3 in a time-division manner. When the switch SW31 is turned on, the second terminal of the switch SW31 outputs the readout result voltage corresponding to the corresponding column line CL1 to the output capacitor Co3 and the analog to digital converter ADC3. Other current-voltage conversion circuits (for example, the current-voltage conversion circuit CVC3n) may be understood by referring to the description about the current-voltage conversion circuit CVC31, and thus will not be described in detail here.

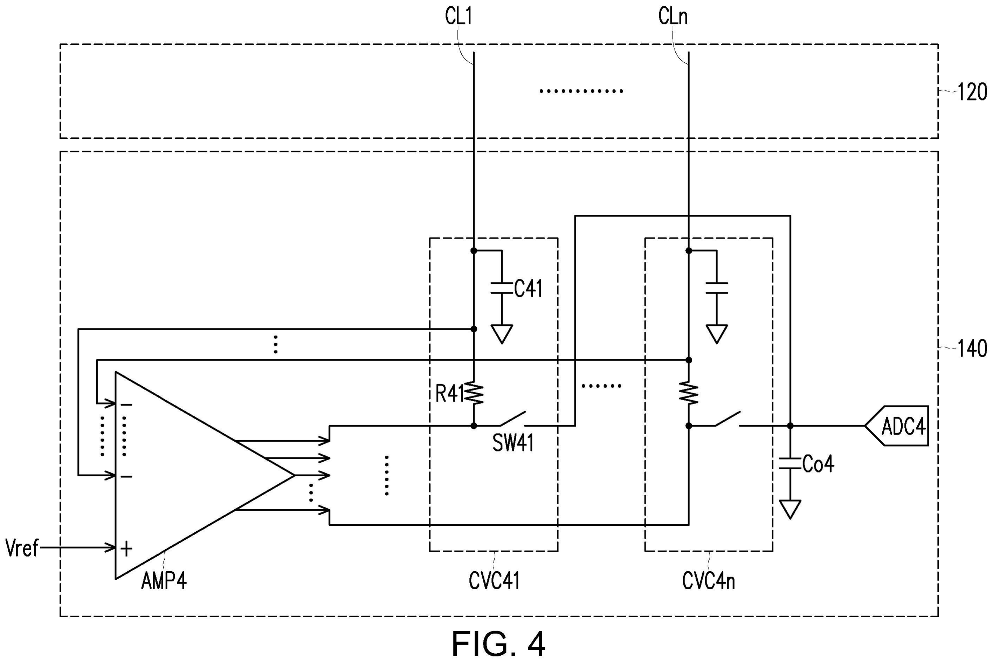

FIG. 4 is a circuit block diagram illustrating a readout circuit 140 according to yet another embodiment of the disclosure. The readout circuit 140 shown in FIG. 4 may serve as one of many exemplary embodiments of the readout circuit 140 shown in FIG. 1. The memristor array 120, the column lines CL1 to CLn, and the readout circuit 140 shown in FIG. 4 may be understood by referring to the description related to FIG. 1. In the embodiment shown in FIG. 4, the readout circuit 140 includes a differential amplifier circuit AMP4, multiple current-voltage conversion circuits (for example, CVC41, ..., CVC4n), an output capacitor Co4, and an analog to digital converter ADC4. The differential amplifier circuit AMP4, the current-voltage conversion circuits CVC41 to CVC4n, the output capacitor Co4, and the analog to digital converter ADC4 shown in FIG. 4 may be understood by referring to the description about the differential amplifier circuit AMP3, the current-voltage conversion circuits CVC31 to CVC3n, the output capacitor Co3, and the analog to digital converter ADC3 shown in FIG. 3, and thus will not be described in detail here.

In the embodiment shown in FIG. 4, each of the current-voltage conversion circuits CVC41 to CVC4n includes a resistor, a switch, and a capacitor. For example, the current-voltage conversion circuit CVC41 includes a resistor R41, a switch SW41, and a capacitor C41. The first terminal of the resistor R41 is coupled to the corresponding column line CL1. The first terminal of the capacitor C41 is coupled to the resistor R41. The second terminal of the capacitor C41 is coupled to a reference voltage source, such as a ground voltage source or other fixed voltage sources (different from the reference voltage source Vref). The second terminal of the resistor R41 is coupled to the corresponding output terminal of the differential amplifier circuit AMP4. The first terminal of the switch SW41 is coupled to the second terminal of the resistor R41. Through the operation of the switch SW41, the current-voltage conversion circuit CVC41 may use the analog to digital converter ADC4 in a time-division manner. When the switch SW41 is turned on, the second terminal of the switch SW41 outputs the readout result voltage corresponding to the corresponding column line CL1 to the output capacitor Co4 and the analog to digital converter ADC4. Other current-voltage conversion circuits (for example, the current-voltage conversion circuit CVC4n) may be understood by referring to the description about the current-voltage conversion circuit CVC41, and thus will not be described in detail here.

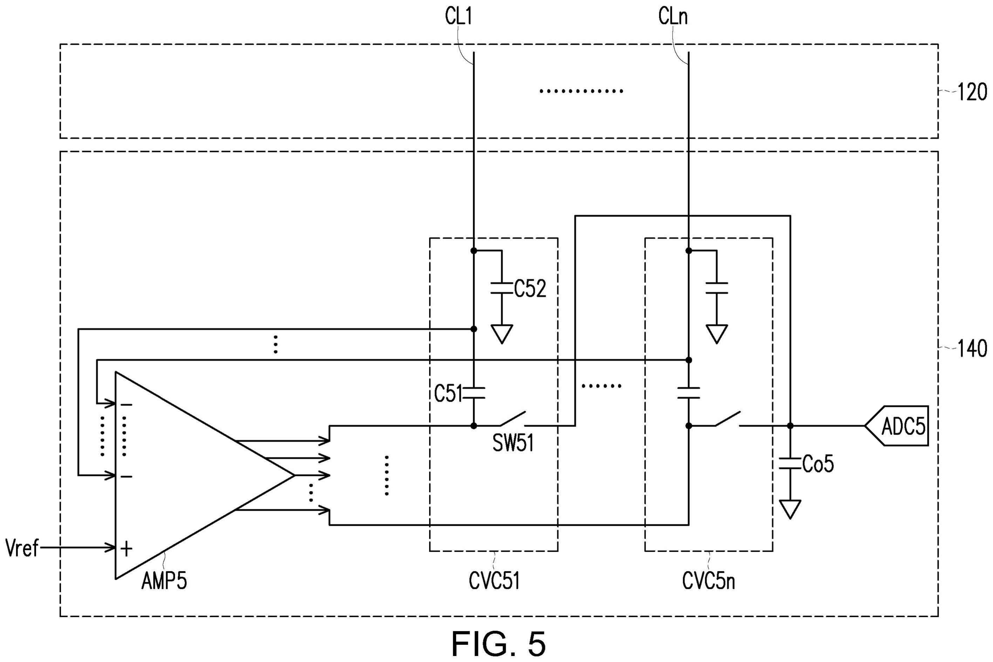

FIG. 5 is a circuit block diagram illustrating a readout circuit 140 according to yet another embodiment of the disclosure. The readout circuit 140 shown in FIG. 5 may serve as one of many exemplary embodiments of the readout circuit 140 shown in FIG. 1. The memristor array 120, the column lines CL1 to CLn, and the readout circuit 140 shown in FIG. 5 may be understood by referring to the description related to FIG. 1. In the embodiment shown in FIG. 5, the readout circuit 140 includes a differential amplifier circuit AMP5, multiple current-voltage conversion circuits (for example, CVC51, ..., CVC5n), an output capacitor Co5, and an analog to digital converter ADC5. The differential amplifier circuit AMP5, the current-voltage conversion circuits CVC51 to CVC5n, the output capacitor Co5, and the analog to digital converter ADC5 shown in FIG. 5 may be understood by referring to the description about the differential amplifier circuit AMP3, the current-voltage conversion circuits CVC31 to CVC3n, the output capacitor Co3, and the analog to digital converter ADC3 shown in FIG. 3, and thus will not be described in detail here.

In the embodiment shown in FIG. 5, each of the current-voltage conversion circuits CVC51 to CVC5n includes a first capacitor, a switch, and a second capacitor. For example, the current-voltage conversion circuit CVC51 includes a capacitor C51, a switch SW51, and a capacitor C52. The first terminal of the capacitor C51 is coupled to the corresponding column line CL1. The first terminal of the capacitor C52 is coupled to the first terminal of the capacitor C51. The second terminal of the capacitor C52 is coupled to a reference voltage source, such as a ground voltage source or other fixed voltage sources (different from the reference voltage source Vref). The second terminal of the capacitor C51 is coupled to the corresponding output terminal of the differential amplifier circuit AMP5. The first terminal of the switch SW51 is coupled to the second terminal of the capacitor C51. Through the operation of the switch SW51, the current-voltage conversion circuit CVC51 may use the analog to digital converter ADC5 in a time-division manner. When the switch SW51 is turned on, the second terminal of the switch SW51 outputs the readout result voltage corresponding to the corresponding column line CL1 to the output capacitor Co5 and the analog to digital converter ADC5. Other current-voltage conversion circuits (for example, the current-voltage conversion circuit CVC5n) may be understood by referring to the description about the current-voltage conversion circuit CVC51, and thus will not be described in detail here.

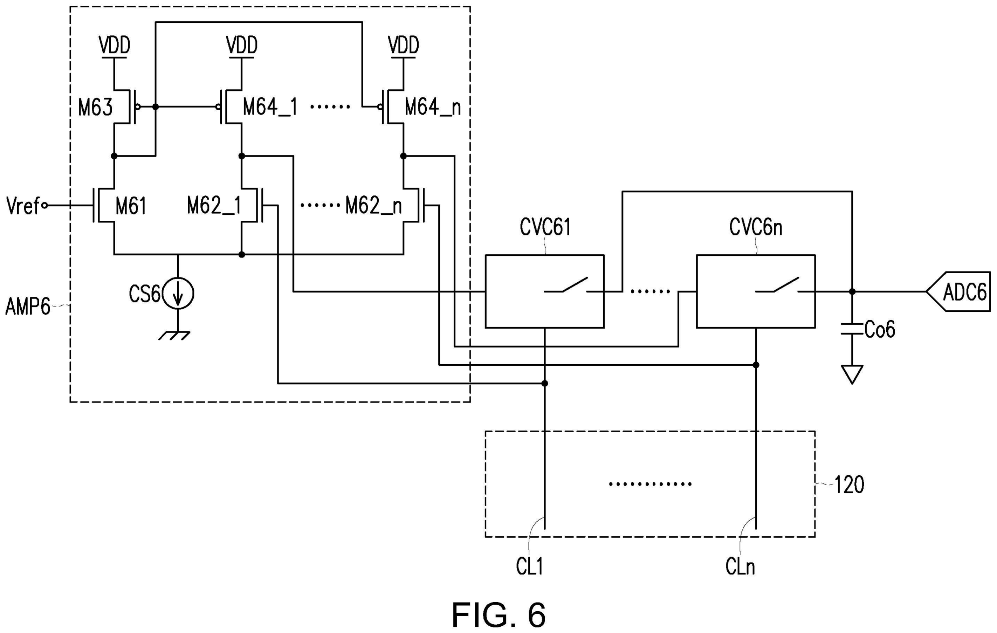

FIG. 6 is a circuit diagram illustrating a differential amplifier circuit AMP6 according to an embodiment of the disclosure. The memristor array 120 and the column lines CL1 to CLn shown in FIG. 6 may be understood by referring to the description related to FIG. 1. The differential amplifier circuit AMP6 shown in FIG. 6 may serve as one of many exemplary embodiments for each of the differential amplifier circuits AMP3 shown in FIG. 3, AMP4 shown in FIG. 4, and AMP5 shown in FIG. 5. The differential amplifier circuit AMP6, the current-voltage conversion circuits CVC61 to CVC6n, the output capacitor Co6, and the analog to digital converter ADC6 shown in FIG. 6 may be understood by referring to the description about the differential amplifier circuit AMP3, the current-voltage conversion circuits CVC31 to CVC3n, the output capacitor Co3, and the analog to digital converter ADC3 shown in FIG. 3, or by referring to the description about the differential amplifier circuit AMP4, the current-voltage conversion circuits CVC41 to CVC4n, the output capacitor Co4, and the analog to digital converter ADC4 shown in FIG. 4, or by referring to the description about the differential amplifier circuit AMP5, the current-voltage conversion circuits CVC51 to CVC5n, the output capacitor Co5, and the analog to digital converter ADC5 shown in FIG. 5.

In the embodiment shown in FIG. 6, the differential amplifier circuit AMP6 includes a current source CS6, a first transistor (for example, transistor M61), multiple second transistors (for example, transistors M62_1, ..., M62_n), a third transistor (for example, transistor M63), and multiple fourth transistors (for example, transistors M64_1, ..., M64_n). The control terminal (for example, gate) of the transistor M61 is coupled to the first input terminal of the differential amplifier circuit AMP6, that is, coupled to a reference voltage source Vref. The first terminal (for example, source) of the transistor M61 is coupled to the current source CS6. The first terminal (for example, source) of each of the transistors M62_1 to M62_n is coupled to the current source CS6. The second input terminals of the differential amplifier circuit AMP6 correspond to the transistors M62_1 to M62_n on a one-to-one basis. The control terminal (for example, gate) of each of the transistors M62_1 to M62_n is coupled to a corresponding second input terminal of the differential amplifier circuit AMP6, that is, coupled to the corresponding one of the column lines CL1 to CLn. For example, the control terminal of the transistor M62_1 is coupled to the column line CL1, while the control terminal of the transistor M62_n is coupled to the column line CLn.

The first terminal (for example, drain) of the transistor M63 is coupled to the second terminal (for example, drain) of the transistor M61 and the control terminal (for example, gate) of the transistor M63. The second terminal (for example, source) of the transistor M63 is coupled to the power voltage source VDD. The transistors M64_1 to M64_n correspond to the transistors M62_1 to M62_n on a one-to-one basis. The output terminals of the differential amplifier circuit AMP6 correspond to the fourth transistors M64_1 to M64_n on a one-to-one basis. The control terminal (for example, gate) of each of the fourth transistors M64_1 to M64_n is coupled to the control terminal of the transistor M63. The first terminal (for example, drain) of each of the transistors M64_1 to M64_n is coupled to the second terminal (for example, drain) of the corresponding one of the transistors M62_1 to M62_n. The second terminal (for example, source) of each of the transistors M64_1 to M64_n is coupled to the power voltage source VDD. The first terminal of each of the transistors M64_1 to M64_n is also coupled to the corresponding one of the output terminals of the differential amplifier circuit AMP6, that is, coupled to the second terminal of the corresponding one of the current-voltage conversion circuits CVC61 to CVC6n. For example, the first terminal of the transistor M64_1 is coupled to the second terminal of the current-voltage conversion circuit CVC61, while the first terminal of the transistor M64_n is coupled to the second terminal of the current-voltage conversion circuit CVC6n.

The differential amplifier circuit AMP6 and the current-voltage conversion circuits CVC61 to CVC6n may convert the total current on each of the column lines CL1 to CLn into a corresponding analog output voltage, and the analog to digital converter ADC6 converts the analog output voltage into digital data for the control circuit 130. The same differential amplifier circuit AMP6 is shared for the readout operations of different column lines CL1 to CLn. Compared to the embodiment shown in FIG. 2, the readout circuit shown in FIG. 6 reduces the number of transistors in the differential amplifier, which also reduces the noise of the amplifier transistors.

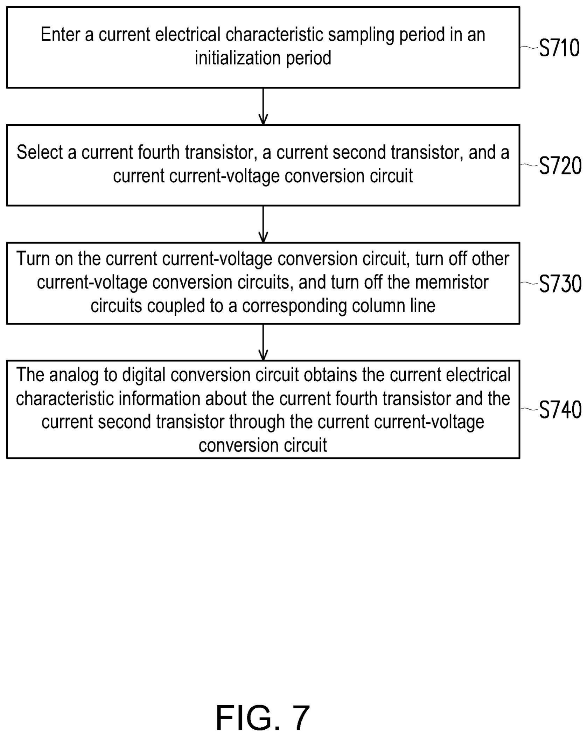

FIG. 7 is a flow chart illustrating an operation method of a readout circuit according to an embodiment of the disclosure. Referring to FIG. 6 and FIG. 7, the analog to digital converter ADC6 may obtain electrical characteristic information about the transistors M64_1 to M64_n one by one during an initialization period for the control circuit 130, so that the control circuit 130 may determine the situation of mismatch among these transistors M64_1 to M64_n. The initialization period is earlier than the programming operations performed on the memristor circuits MR11 to MRmn of the column lines CL1 to CLn. After entering one (present electrical characteristic sampling period) of multiple electrical characteristic sampling periods in the initialization period (step S710), the control circuit 130 selects one of the transistors M64_1 to M64_n as the present fourth transistor, selects one of the transistors M62_1 to M62_n coupled to the present fourth transistor as the present second transistor, and selects one of the current-voltage conversion circuits CVC61 to CVC6n coupled to the present fourth transistor as the present current-voltage conversion circuit (step S720). In step S730, the control circuit 130 turns on the output terminal of the present current-voltage conversion circuit, and turns off the output terminals of other current-voltage conversion circuits CVC61 to CVC6n except the present current-voltage conversion circuit. One of the column lines CL1 to CLn coupled to the present current-voltage conversion circuit is defined as a "corresponding column line". The control circuit 130 also turns off all the memristor circuits coupled to the corresponding column line in step S730. In step S740, the analog to digital converter ADC6 obtains present electrical characteristic information about the present fourth transistor and the present second transistor for the control circuit 130 through the present current-voltage conversion circuit.

For example, the initialization period includes n electrical characteristic sampling periods. The analog to digital converter ADC6 obtains electrical characteristic information about the transistors M64_1 and M62_1 in the first electrical characteristic sampling period, and obtains electrical characteristic information about the transistors M64_n and M62_n in the n^{th} electrical characteristic sampling period. It is assumed that in the present electrical characteristic sampling period, the control circuit 130 selects the transistor M64_1 as the present fourth transistor, selects the transistor M62_1 as the present second transistor, and selects the current-voltage conversion circuit CVC61 as the present current-voltage conversion circuit. In step S730, the control circuit 130 turns on the output terminal of the current-voltage conversion circuit CVC61, turns off the output terminals of other current-voltage conversion circuits (for example, CVC6n), and turns off the memristor circuits MR11, MR21, ..., MRm1 coupled to the corresponding column line CL1. Therefore, the analog to digital converter ADC6 may obtain present electrical characteristic information about the transistors M64_1 and M62_1 for the control circuit 130 through the current-voltage conversion circuit CVC61.

In some applications, the control circuit 130 may record the electrical characteristic information about the transistors M64_1 to M64_n and M62_1 to M62_n in a lookup table for use in a correction operation (which will be described in detail later). In other applications, the control circuit 130 may convert the electrical characteristic information about the transistors M64_1 to M64_n and M62_1 to M62_n into mismatch information based on reference electrical characteristic information, and then record the mismatch information about the transistors M64_1 to M64_n and M62_1 to M62_n in the lookup table for use in a correction operation.

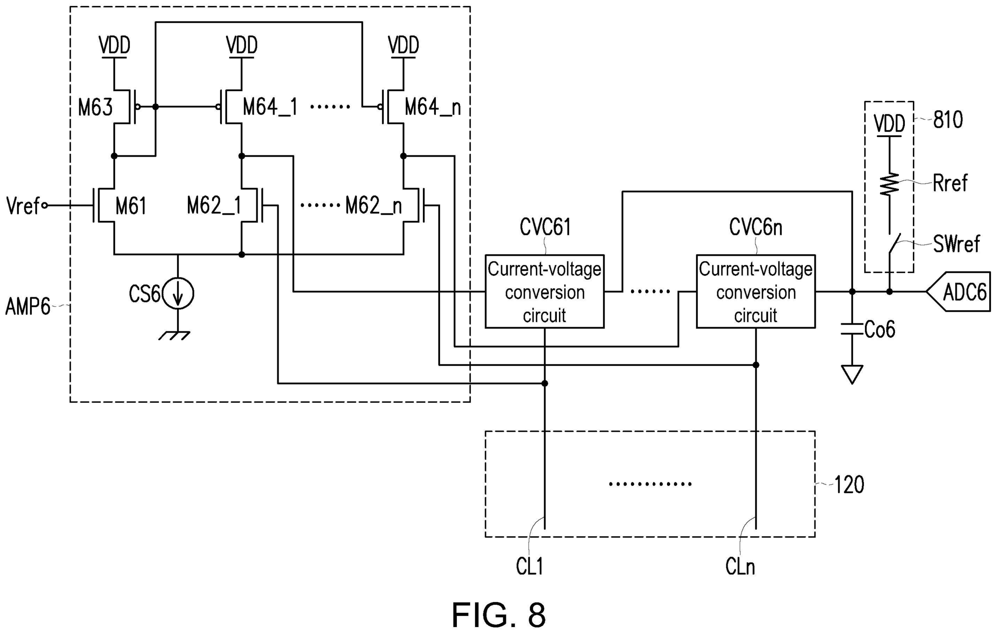

FIG. 8 is a circuit block diagram illustrating a readout circuit according to an embodiment of the disclosure. The differential amplifier circuit AMP6, the current-voltage conversion circuits CVC61 to CVC6n, the output capacitor Co6, the analog to digital converter ADC6, the memristor array 120, and the column lines CL1 to CLn shown in FIG. 8 may be understood by referring to the description related to FIG. 6, and thus will not be described in detail here. Unlike the embodiment shown in FIG. 6, the readout circuit shown in FIG. 8 further includes a reference circuit 810. The analog to digital converter ADC6 may obtain reference electrical characteristic information about the reference circuit 810 from the reference circuit 810. In the embodiment shown in FIG. 8, the reference circuit 810 includes a reference resistor Rref and a switch SWref. The reference resistor Rref and the switch SWref are connected in series between the power voltage source VDD and the input terminal of the analog to digital converter ADC6.

During the reference electrical characteristic sampling period in the initialization period, the control circuit 130 turns off the output terminal of each of the current-voltage conversion circuits CVC61 to CVC6n, and turns on the reference circuit 810 (that is, turns on the switch SWref). At this time, the analog to digital converter ADC6 may obtain the reference electrical characteristic information about the reference circuit 810, and then the control circuit 130 may record the reference electrical characteristic information in the lookup table. After the reference electrical characteristic sampling period ends, the control circuit 130 turns off the reference circuit 810 (that is, turns off the switch SWref). Next, during n electrical characteristic sampling periods in the initialization period, the control circuit 130 obtains present mismatch information about the present fourth transistor and the present second transistor based on the difference between the reference electrical characteristic information and the present electrical characteristic information, and records the present mismatch information in the lookup table for use in a correction operation (which will be described in detail later).

The control circuit 130 can select one of the current-voltage conversion circuits CVC61 to CVC6n and that activate a corresponding one of the transistors M62_1 to M62_n. For example, it is assumed that in the present electrical characteristic sampling period, the control circuit 130 selects the transistor M64_1 as the present fourth transistor, selects the transistor M62_1 as the present second transistor, and selects the current-voltage conversion circuit CVC61 as the present current-voltage conversion circuit. The control circuit 130 turns on the output terminal of the current-voltage conversion circuit CVC61, turns off the output terminals of other current-voltage conversion circuits (for example, CVC6n), and turns off the memristor circuits MR11, MR21, ..., MRm1 coupled to the corresponding column line CL1. Therefore, the analog to digital converter ADC6 may obtain the present electrical characteristic information about the transistors M64_1 and M62_1 for the control circuit 130 through the current-voltage conversion circuit CVC61. Then, the control circuit 130 obtains the present mismatch information about the transistors M64_1 and M62_1 based on the difference between "the reference electrical characteristic information about the reference circuit 810" and "the present electrical characteristic information about the transistors M64_1 and M62_1". The control circuit 130 then records the mismatch information about the transistors M64_1 and M62_1 in the lookup table for use in a correction operation (which will be described in detail later).

The initialization period is earlier than the programming operation performed on the corresponding column line coupled to the present current-voltage conversion circuit. The programming operation performed on the corresponding column line includes multiple iterative operations, each of which is used to program the corresponding one of the memristor circuits coupled to the corresponding column line. Each iterative operation includes: setting a target resistance value with a first resolution; programming the corresponding one of the memristor circuits coupled to the corresponding column line; the analog to digital converter ADC6 reading the present resistance value of the corresponding one of the memristor circuits coupled to the corresponding column line with a second resolution higher than the first resolution; selectively compensating the present resistance value to generate a compensated resistance value based on the present electrical characteristic information or the present mismatch information about the present fourth transistor and the present second transistor; and checking the target resistance value and the compensated resistance value to determine whether to end the iterative operation.

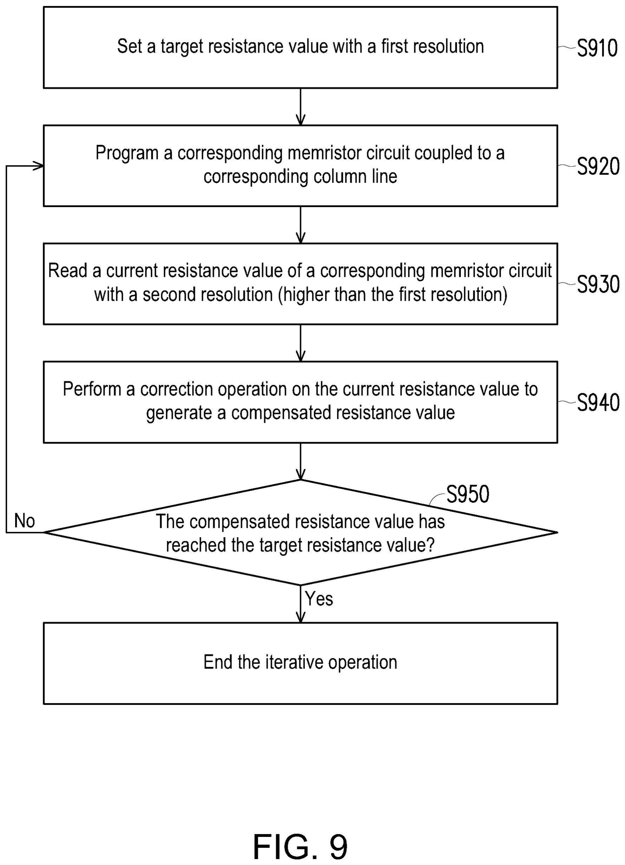

FIG. 9 is a flow chart illustrating an iterative operation according to an embodiment of the disclosure. To facilitate the illustration, it is assumed here that the present fourth transistor is M64_1, the present second transistor is M62_1, the "corresponding column line" is the column line CL1, and the corresponding memristor circuit coupled to the column line CL1 is the memristor circuit MR11. Other column lines (for example, column line CLn) may be understood by referring to the description about the column line CL1, and the programming for other memristor circuits may be understood by referring to the description about the memristor circuit MR11. In step S910, the control circuit 130 sets a target resistance value with a first resolution. The first resolution may be determined according to the actual application. For example (but not limited to), the first resolution may be 4 bits or other resolutions. In step S920, the drive circuit 110 and the readout circuit 140 cooperate to program the memristor circuit MR11 coupled to the column line CL1. When programming the memristor circuit MR11, the memristor circuit MR11 is turned on, while other memristor circuits are turned off. The programming operation for the memristor may include known programming operations or other programming operations. After completing step S920, the control circuit 130 proceeds with step S930, step S940, and step S950 to verify whether the present resistance value of the memristor circuit MR11 has reached the target resistance value.

In step S930, the analog to digital converter ADC6 reads the present resistance value of the memristor circuit MR11 coupled to the column line CL1 with a second resolution (higher than the first resolution). The second resolution may be determined according to the actual application. For example (but not limited to), the second resolution may be 6 bits or other resolutions. In step S940, based on the present electrical characteristic information (or present mismatch information) on the transistors M64_1 and M62_1 recorded in the lookup table, the control circuit 130 selectively compensates the present resistance value of the memristor circuit MR11 to generate a compensated resistance value. In step S950, the control circuit 130 checks the target resistance value and the compensated resistance value of the memristor circuit MR11 to determine whether to end the iterative operation of the memristor circuit MR11. In the case where the compensated resistance value does not reach the target resistance value (the result of determination in step S950 is "No"), the control circuit 130 enters step S920 again. In the case where the compensated resistance value has reached the target resistance value (the result of determination in step S950 is "Yes"), the control circuit 130 ends the iterative operation of the memristor circuit MR11.

The programming operation for the memristor circuits MR11 to MRmn is earlier than the readout operation (or analog in-memory computing operation) for the memristor circuits MR11 to MRmn. The analog to digital converter ADC6 may obtain current information of the column lines CL1 to CLn one by one for the control circuit 130 during the readout operation. The readout operation includes: the analog to digital converter ADC6 reading the total current value of the memristor circuits coupled to the corresponding column line with a first resolution (for example, 4 bits or other resolutions). For example, it is assumed that the "corresponding column line" is the column line CL1. The total current on the column line CL1 is equivalent to the multiply accumulation result after accumulating different multiplication results of the memristor circuits MR11, MR21, ..., MRm1 in the same column. The differential amplifier circuit AMP6 and the current-voltage conversion circuit CVC61 convert the total current of the memristor circuits MR11, MR21, ..., MRm1 on the column line CL1 into a corresponding analog output voltage (at this time, the output terminals of other current-voltage conversion circuits are turned off), and the analog to digital converter ADC6 converts the corresponding analog output voltage of the column line CL1 into digital data for the control circuit 130 with the first resolution. The readout operations (or analog in-memory computing operations) for other column lines CL2 to CLn may be understood by referring to the description about the column line CL1, and thus will not be described in detail here.

In summary, the first terminal and the second terminal of each of the memristor circuits MR11 to MRmn are coupled to a corresponding row line and a corresponding column line, respectively. Multiple elements (weight values) of the weight matrix of the neural network are programmed in the form of conductance into different memristor circuits MR11 to MRmn of the memristor array 120. Based on the control of the control circuit 130, the drive circuit 110 converts different elements (input values) of the input matrix of a certain computation layer in the neural network into multiple analog input voltages for the row lines RL1 to RLm. These analog input voltages are respectively transmitted to different memristor circuits in the same column through different row lines RL1 to RLm, causing these memristor circuits to generate different output currents to the same column line. The total current on the same column line is equivalent to the multiply accumulation result, and the different total currents on these column lines CL1 to CLn are equivalent to the matrix multiplication result of the input matrix multiplied by the weight matrix. Therefore, the analog in-memory computing device 100 is capable of performing matrix multiplication of the neural network. Furthermore, the readout circuit 140 of the memristor array 120 may convert the total current on each of the column lines CL1 to CLn into a corresponding analog output voltage, and then convert the corresponding analog output voltage into digital data for the control circuit 130. The readout circuit 140 shares the same differential amplifier circuit AMP6 for readout operations of different column lines CL1 to CLn. Thus, the readout circuit 140 reduces the number of transistors in the differential amplifier circuit.

## Claims

1. An analog in-memory computing device (100) for a neural network, **characterized in that** the analog in-memory computing device (100) comprising:
a memristor array (120) comprising a plurality of memristor circuits (MR11 to MRmn), a plurality of column lines (CL1 to CLn), and a plurality of row lines (RL1 to RLm), wherein a first terminal of each of the memristor circuits (MR11 to MRmn) is coupled to a corresponding one of the row lines (RL1 to RLm), and a second terminal of each of the memristor circuits (MR11 to MRmn) is coupled to a corresponding one of the column lines (CL1 to CLn); and
a readout circuit (140) coupled to the column lines (CL1 to CLn), wherein the readout circuit (140) comprises:
a differential amplifier circuit (AMP3, AMP4, AMP5, AMP6) comprising a first input terminal, a plurality of second input terminals, and a plurality of output terminals, wherein the first input terminal is one of an inverting input terminal and a non-inverting input terminal, each of the second input terminals is the other one of the inverting input terminal and the non-inverting input terminal, the output terminals correspond to the second input terminals on a one-to-one basis, the first input terminal is coupled to a first reference voltage source (Vref), and each of the second input terminals is coupled to a corresponding one of the column lines (CL1 to CLn); and
a plurality of current-voltage conversion circuits (CVC31 to CVC3n, CVC41 to CVC4n, CVC51 to CVC5n, CVC61 to CVC6n), wherein a first terminal of each of the current-voltage conversion circuits (CVC31 to CVC3n, CVC41 to CVC4n, CVC51 to CVC5n, CVC61 to CVC6n) is coupled to a corresponding one of the column lines (CL1 to CLn), a second terminal of each of the current-voltage conversion circuits (CVC31 to CVC3n, CVC41 to CVC4n, CVC51 to CVC5n, CVC61 to CVC6n) is coupled to a corresponding one of the output terminals of the differential amplifier circuit (AMP3, AMP4, AMP5, AMP6), and an output terminal of each of the current-voltage conversion circuits (CVC31 to CVC3n, CVC41 to CVC4n, CVC51 to CVC5n, CVC61 to CVC6n) outputs a readout result voltage corresponding to a corresponding one of the column lines (CL1 to CLn).

2. The analog in-memory computing device (100) according to claim 1, wherein each of the memristor circuits (MR11) comprises:
a memristor (121) storing one of a plurality of weights of the neural network; and
a switch (122), wherein the memristor and the switch are connected in series between the first terminal and the second terminal of the memristor circuit (MR11).

3. The analog in-memory computing device (100) according to claim 1, wherein each of the current-voltage conversion circuits (CVC31 to CVC3n) comprises:
a resistor (R31), wherein a first terminal of the resistor (R31) is coupled to a power voltage source (VDD);
a transistor (M31), wherein a first terminal of the transistor (M31) is coupled to a second terminal of the resistor (R31), a second terminal of the transistor (M31) is coupled to a corresponding one of the column lines (CL1 to CLn), and a control terminal of the transistor (M31) is coupled to a corresponding one of the output terminals of the differential amplifier circuit (AMP3);
a switch (SW31), wherein a first terminal of the switch (SW31) is coupled to the second terminal of the resistor (R31), and a second terminal of the switch (SW31) outputs a readout result voltage corresponding to a corresponding one of the column lines (CL1 to CLn); and
a capacitor (C31) coupled between the second terminal of the transistor (M31) and a second reference voltage source.

4. The analog in-memory computing device (100) according to claim 3, wherein the first reference voltage source (Vref) is different from the second reference voltage source.

5. The analog in-memory computing device (100) according to claim 1, wherein each of the current-voltage conversion circuits (CVC41 to CVC4n) comprises:
a resistor (R41), wherein a first terminal of the resistor (R41) is coupled to a corresponding one of the column lines (CL1 to CLn), and a second terminal of the resistor (R41) is coupled to a corresponding one of the output terminals of the differential amplifier circuit (AMP4);
a capacitor (C41) coupled between the first terminal of the resistor (R41) and a second reference voltage source; and
a switch (SW41), wherein a first terminal of the switch (SW41) is coupled to the second terminal of the resistor (R41), and a second terminal of the switch (SW41) outputs a readout result voltage corresponding to a corresponding one of the column lines (CL1 to CLn).

6. The analog in-memory computing device (100) according to claim 5, wherein the first reference voltage source (Vref) is different from the second reference voltage source.

7. The analog in-memory computing device (100) according to claim 1, wherein each of the current-voltage conversion circuits (CVC51 to CVC5n) comprises:
a first capacitor (C51), wherein a first terminal of the first capacitor (C51) is coupled to a corresponding one of the column lines (CL1 to CLn), and a second terminal of the first capacitor (C51) is coupled to a corresponding one of the output terminals of the differential amplifier circuit (AMP5);
a second capacitor (C52) coupled between the first terminal of the first capacitor (C51) and a second reference voltage source; and
a switch (SW51), wherein a first terminal of the switch (SW51) is coupled to the second terminal of the first capacitor (C51), and a second terminal of the switch (SW51) outputs a readout result voltage corresponding to a corresponding one of the column lines (CL1 to CLn).

8. The analog in-memory computing device (100) according to claim 7, wherein the first reference voltage source (Vref) is different from the second reference voltage source.

9. The analog in-memory computing device (100) according to claim 1, wherein the readout circuit (140) further comprises:
an output capacitor (Co3, Co4, Co5, Co6) coupled to the output terminal of each of the current-voltage conversion circuits (CVC31 to CVC3n, CVC41 to CVC4n, CVC51 to CVC5n, CVC61 to CVC6n); and
an analog to digital converter (ADC3, ADC4, ADC5, ADC6), wherein an input terminal of the analog to digital converter (ADC3, ADC4, ADC5, ADC6) is coupled to the output terminal of each of the current-voltage conversion circuits (CVC31 to CVC3n, CVC41 to CVC4n, CVC51 to CVC5n, CVC61 to CVC6n).

10. The analog in-memory computing device (100) according to claim 1, wherein the differential amplifier circuit (AMP6) comprises:
a current source (CS6);
a first transistor (M61), wherein a control terminal of the first transistor (M61) is coupled to the first input terminal of the differential amplifier circuit (AMP6), and a first terminal of the first transistor (M61) is coupled to the current source (CS6);
a plurality of second transistors (M62_1 to M62_n), wherein the second input terminals of the differential amplifier circuit (AMP6) correspond to the second transistors (M62_1 to M62_n) on a one-to-one basis, a control terminal of each of the second transistors (M62_1 to M62_n) is coupled to a corresponding one of the second input terminals of the differential amplifier circuit (AMP6), and a first terminal of each of the second transistors (M62_1 to M62_n) is coupled to the current source (CS6);
a third transistor (M63), wherein a first terminal of the third transistor (M63) is coupled to a second terminal of the first transistor (M61) and a control terminal of the third transistor (M63), and a second terminal of the third transistor (M63) is coupled to a power voltage source (VDD); and
a plurality of fourth transistors (M64_1 to M64_n), wherein the fourth transistors (M64_1 to M64_n) correspond to the second transistors (M62_1 to M62_n) on a one-to-one basis, the output terminals of the differential amplifier circuit (AMP6) correspond to the fourth transistors (M64_1 to M64_n) on a one-to-one basis, a control terminal of each of the fourth transistors (M64_1 to M64_n) is coupled to the control terminal of the third transistor (M63), a first terminal of each of the fourth transistors (M64_1 to M64_n) is coupled to a second terminal of a corresponding one of the second transistors (M62_1 to M62_n) and a corresponding one of the output terminals of the differential amplifier circuit (AMP6), and a second terminal of each of the fourth transistors is coupled to the power voltage source (VDD).

11. The analog in-memory computing device (100) according to claim 10, wherein,
during a present electrical characteristic sampling period in an initialization period, one of the fourth transistors (M64_1 to M64_n) is selected as a present fourth transistor, one of the second transistors (M62_1 to M62_n) coupled to the present fourth transistor is selected as a present second transistor, one of the current-voltage conversion circuits (CVC61 to CVC6n) coupled to the present fourth transistor is selected as a present current-voltage conversion circuit, the output terminal of the present current-voltage conversion circuit is turned on, the output terminals of other current-voltage conversion circuits (CVC61 to CVC6n) except the present current-voltage conversion circuit are turned off, one of the column lines (CL1 to CLn) coupled to the present current-voltage conversion circuit is a corresponding column line, the memristor circuits (MR11 to MRmn) coupled to the corresponding column line are turned off, and an analog to digital converter (ADC6) of the readout circuit (140) obtains present electrical characteristic information about the present fourth transistor and the present second transistor through the present current-voltage conversion circuit.

12. The analog in-memory computing device (100) according to claim 11, wherein the present electrical characteristic information is recorded in a lookup table for use in a correction operation.

13. The analog in-memory computing device (100) according to claim 11, wherein,
during a reference electrical characteristic sampling period in the initialization period, the output terminal of each of the current-voltage conversion circuits (CVC61 to CVC6n) is turned off, a reference circuit (810) of the readout circuit (140) is turned on, the analog to digital converter (ADC6) obtains reference electrical characteristic information about the reference circuit (810), the analog to digital converter (ADC6) obtains present mismatch information about the present fourth transistor and the present second transistor based on a difference between the reference electrical characteristic information and the present electrical characteristic information, and the present mismatch information is recorded in a lookup table.

14. The analog in-memory computing device (100) according to claim 11, wherein the initialization period is earlier than a programming operation performed on the corresponding column line coupled to the present current-voltage conversion circuit.

15. The analog in-memory computing device (100) according to claim 14, wherein the programming operation performed on the corresponding column line comprises a plurality of iterative operations, each of the iterative operations is configured to program a corresponding one of the memristor circuits (MR11 to MRmn) coupled to the corresponding column line, and each of the iterative operations comprises:
setting a target resistance value with a first resolution;
programming the corresponding one of the memristor circuits (MR11 to MRmn) coupled to the corresponding column line;
reading a present resistance value of the corresponding one of the memristor circuits (MR11 to MRmn) coupled to the corresponding column line by the analog to digital converter (ADC6) with a second resolution higher than the first resolution;
selectively compensating the present resistance value to generate a compensated resistance value based on present electrical characteristic information or present mismatch information about the present fourth transistor and the present second transistor; and
checking the target resistance value and the compensated resistance value to determine whether to end the iterative operation.

16. The analog in-memory computing device (100) according to claim 15, wherein the first resolution is 4-bit resolution, and the second resolution is 6-bit resolution.

17. The analog in-memory computing device (100) according to claim 15, wherein the programming operation is earlier than a readout operation performed on the corresponding column line coupled to the present current-voltage conversion circuit, and the readout operation comprises:
reading a total current value of the memristor circuits (MR11 to MRmn) coupled to the corresponding column line by the analog to digital converter (ADC6) with the first resolution.
